Europäisches Patentamt

European Patent Office

Office européen des brevets

(11) Numéro de publication : **0 600 787 A1**

# DEMANDE DE BREVET EUROPEEN

(21) Numéro de dépôt : **93402898.6**

(22) Date de dépôt : **30.11.93**

(51) Int. Cl.⁵ : **C23C 18/24**

(30) Priorité : **04.12.92 FR 9214638**

(43) Date de publication de la demande :
**08.06.94 Bulletin 94/23**

(84) Etats contractants désignés :
**DE FR GB IT NL**

(71) Demandeur : **THOMSON-CSF**
**173, Boulevard Haussmann**
**F-75008 Paris (FR)**

(72) Inventeur : **Brule, Michel**
**THOMSON-CSF,**
**SCPI,**
**BP 329**
**F-92402 Courbevoie Cedex (FR)**
Inventeur : **Chardin, Christian**
**THOMSON-CSF,**
**SCPI,**
**BP 329**
**F-92402 Courbevoie Cedex (FR)**
Inventeur : **Cosson, Michel**
**THOMSON-CSF,**
**SCPI,**
**BP 329**
**F-92402 Courbevoie Cedex (FR)**

(74) Mandataire : **Albert, Claude et al**
**THOMSON-CSF**
**SCPI**
**B.P. 329**
**50, rue J.P. Timbaud**
**F-92402 COURBEVOIE CEDEX (FR)**

(54) **Procédé pour la métallisation de surface de pièces en matériau composite à matrice organique, et pièces à usage électronique ainsi obtenues.**

(57)    L'invention concerne un procédé pour la métallisation de la surface de pièces en matériau composite et les pièces ainsi obtenues.

Pour métalliser une pièce en matériau composite (1), tel qu'un composite fibre de carbone/résine époxyde ou fibre aramide/résine époxyde, le procédé consiste à :

— préparer par voie chimique la surface du composite pour obtenir un micro-satinage ;

— étuver pour déshydrater et sécher ;

— déposer par voie chimique une sous-couche mince (2) d'un métal catalytique tel que le palladium ;

— réaliser un dépôt métallique (3) intermédiaire par voie chimique, tel que le nickel chimique ;

— déposer une couche finale (4) d'un métal très bon conducteur électrique par voie électrolytique ou chimique, ou de métal possédant de bonnes aptitudes aux brasages tendres, tels que l'argent ou l'étain.

L'invention s'applique à la réalisation de pièces en matériau composite métallisées pour des applications de pièce de structure à usage électronique.

EP 0 600 787 A1

La présente invention se rapporte à un procédé pour la métallisation de la surface de pièces en matériau composite à matrice organique et aux pièces de structure mécanique ou autres à usage électronique obtenues par ce procédé.

Dans le matériel aéroporté notamment, on recherche de plus en plus à remplacer des pièces métalliques par des pièces en matériau composite plus légères et aussi résistantes. Ces pièces en matériau composite doivent toutefois être métallisées pour présenter les performances électriques nécessaires.

On sait déjà métalliser certains matériaux plastiques courants ou même plus récents, comme le polyéthersulfone ou les polymères à cristaux liquides, utilisés dans une large gamme d'applications industrielles.

Dans le domaine du matériel aéroporté en général et surtout dans le domaine du matériel électronique de pointe, il est nécessaire de trouver des matériaux composites permettant la fabrication de pièces de structure répondant à des critères de légèreté, tenue mécanique, fiabilité de mise en oeuvre par stratification ou drapage et permettant l'équipotentialité électrique avec d'une part, les composants électroniques assemblés à l'intérieur de ces pièces de structure, et d'autre part, les autres ensembles sur lesquelles sont fixées ces structures. C'est le cas par exemple des composites fibre de carbone/résine époxyde ou fibres Aramides/résine époxyde.

Cependant, l'inconvénient de ces matériaux composites est que l'on ne sait pas actuellement les métalliser convenablement de manière à obtenir les caractéristiques d'adhérence de dépôt, d'état de surface et de conductivité électrique nécessaires pour les applications de pièces de structure envisagées. En effet, pour les applications électroniques envisagées, en particulier dans le cas d'utilisation dans des conditions d'environnement sévères, il est nécessaire d'avoir une excellente qualité de surface de la métallisation pour obtenir l'équipotentialité recherchée et les qualités électriques requises et, en même temps, d'avoir un état physique de la surface du composite suffisamment rugueuse pour assurer l'adhérence indispensable, ces deux exigences étant a priori contradictoires et n'étant pas remplies ensemble dans les procédés de métallisation de matériau plastique connus.

Un objet de la présente invention est donc un procédé de métallisation de matériau composite à matrice organique remédiant à ces inconvénients.

Selon l'invention, il est prévu un procédé pour la métallisation de la surface de pièces en matériau composite à matrice organique, dans lequel on prépare chimiquement la surface desdites pièces puis on dépose une sous-couche mince d'un premier métal assurant l'adhérence, enfin on effectue un dépôt d'une couche d'un autre métal, ledit procédé étant caractérisé en ce qu'il comporte les étapes consistant à :
- dégraisser et décaper chimiquement les pièces ;
- effectuer une neutralisation chimique ;
- obtenir un micro-satinage de la surface des pièces ;
- étuver pour déshydrater et dégazer lesdites pièces ;
- déposer par voie chimique une sous-couche très mince d'un métal catalytique ;
- réaliser un dépôt métallique intermédiaire par voie chimique pour assurer la continuité électrique sur toute la surface des pièces ; et
- déposer une couche finale de métal très bon conducteur électrique et résistant aux conditions d'environnement, par voie électrolytique ou chimique.

Dans un mode de réalisation particulier, ce procédé met à profit la grande cohésion du palladium en sous-couche, avec le dépôt intermédiaire de nickel chimique et le dépôt final d'argent, ainsi que les qualités du palladium lorsque la surface du matériau a été préparée et activée comme indiqué.

Selon un autre aspect, l'invention concerne également une pièce en matériau composite à base de résine époxy chargée par des fibres de carbone ou aramides recouvert par au moins une couche métallique électriquement bonne conductrice, caractérisée en ce que la surface micro-satinée dudit matériau composite est recouverte d'une sous-couche mince de palladium, d'un dépôt intermédiaire en nickel et d'une couche finale en argent.

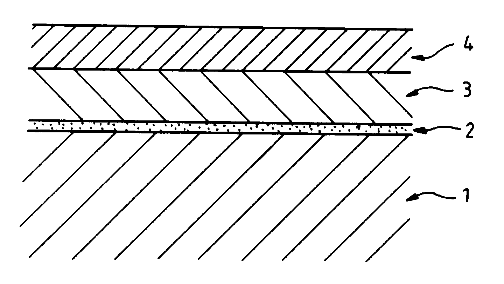

L'invention sera mieux comprise et d'autres caractéristiques et avantages apparaîtront à l'aide de la description ci-après et de la figure unique jointe montrant en coupe un exemple de pièce selon l'invention.

Comme on l'a déjà mentionné plus haut, le problème de la métallisation de matériaux composites résolu par l'invention est particulièrement difficile dans le cas des matériaux utilisant des tissus de fibre de carbone ou de fibres Aramides, enrobés de résine époxyde.

Des exemples typiques de matériaux sont :
* préimprimé fibre de carbone/résine époxyde :
    VICOTEX 914/42/G803
    Sté BROCHIER et CIBA-GEIGY
* tissu de fibre Aramide/résine époxyde :
    VICOTEX 914/45/914

Sté BROCHIER et CIBA-GEIGY

On décrira le procédé selon l'invention dans le cadre de son application sur stratifié fibre de carbone/résine époxyde avec une métallisation par sous-couche fine catalytique déposé par voie chimique, un dépôt intermédiaire de nickel obtenu par voie chimique et un dépôt final d'argent obtenu par voie électrolytique, sans que cela soit en rien limitatif de l'invention.

Plus particulièrement pour le composite fibres de carbone/résine époxyde 1 on utilise pour la sous-couche catalytique 2 un métal de la mine du platine, et de préférence le palladium, pour la sous-couche intermédiaire 3 un dépôt de nickel chimique, et , pour la couche finale 4 de l'argent pur. Cet ensemble possédant une très bonne cohésion entre chaque métal, une grande résistance aux environnements sévères (brouillards salins, chaleur humide, chocs thermiques -55 + 125°C...), et des qualités de continuité électrique de surface proche de l'argent métal obtenu par procédé métallurgique conventionnel.

Une mise en oeuvre préférée du procédé selon l'invention est décrite en détails ci-dessous.

Dans une première étape, la pièce en composite fibre de carbone/résine époxyde subit un dégraissage chimique dans une lessive alcaline du type REVIT T12 (Sté SEVIT) avec des ultra-sons pour assurer la mouillabilité ; les conditions utilisées dans cette étape sont:

température        : 65°C ± 3°C
durée               : 10 mn ± 1 mn

La seconde étape est un décapage dans un bain d'acide nitrique concentré contenant 10% ± 1% d'acide fluorhydrique à la température ambiante pendant une durée de l'ordre de 5 mn ± 1 mn.

La troisième étape est une neutralisation dans un bain de bicarbonate de sodium avec une concentration de l'ordre de 40 à 60 g/l à la température ambiante pendant une durée sensiblement comprise entre 3 et 15 mn.

Dans un mode de réalisation préféré, on choisit une concentration de 50g/l et une durée de 5 mn ± 1 mn.

La quatrième étape consiste à micro-satiner la surface du composite. Cette étape est une des plus importantes dans le cycle de préparation car c'est celle qui conditionne la qualité de la métallisation en terme d'adhérence mais également d'état de surface.

Le micro-satinage s'effectue dans un bain acide comprenant de l'acide chromique à une concentration sensiblement comprise entre 400 et 450 g/l et de l'acide sulfurique à une concentration sensiblement comprise entre 180 et 240 ml/l, à une température de l'ordre de 68 à 76°C pendant une durée de 4 à 8 mn.

Un microsatinage optimum est obtenu pour les pièces en composite fibres de carbone/résine époxyde dans les conditions suivantes.

acide chromique        420g/l
acide sulfurique       200ml/l
température             70°C ± 2°C
durée                  5 mn ± 30 sec

La cinquième étape est un étuvage pour déshydrater et dégazer la pièce. Cette étape est importante car le matériau a absorbé dans la masse de l'humidité qui est nuisible pour les étapes ultérieures. Cet étuvage est effectué à une température d'environ 130°C ± 5°C pendant une durée de l'ordre de 2h ± 30 mn.

A ce stade, la surface de la pièce en composite est apte à recevoir les dépôts métalliques en assurant une bonne adhérence.

La sixième étape est un bain de conditionnement de la surface : conditionner 231 (Sté SHIPLEY) à la température de 65°C ± 3°C pendant une durée de l'ordre de 8 mn ± 1 mn.

La septième étape est le dépôt de la sous-couche fine de palladium obtenue dans le bain cataposit 44 (Sté SHIPLEY) contenant du palladium colloïdal en présence de chlorure stanneux. Cette opération se fait à une température de 40°C ± 3°C pendant une durée de 6 mn ± 30 sec.

Le dépôt de palladium colloïdal permet un ensemencement pour les dépôts ultérieurs, les "germes" de palladium venant occuper les pores du substrat pour catalyser le dépôt ultérieur de métal.

La huitième étape consiste à éliminer le chlorure stanneux dans un bain Accelerator 19 (Sté SHIPLEY) à la température ambiante pendant une durée de l'ordre de 7 mn ± 1 mn.

La neuvième étape consiste à déposer la sous-couche intermédiaire de nickel chimique dans un bain du type nicklad 1000 (Sté CAPOL) ou autre. Les conditions opératoires sont sensiblement les suivantes :

température        : 88 °C ± 1 °C
durée              : 90 mn + 10 mn
épaisseur          : 15 µm ± 1 µm
pH                 : 5 ± 0,2

Bien entendu, l'épaisseur de la couche indiquée n'est qu'un ordre de grandeur donné à titre d'exemple et peut être largement modifiée.

La dixième étape consiste à déposer la couche finale d'argent assurant la bonne conductibilité électrique.

Le dépôt s'effectue dans un bain électrolytique du type AG056 (Sté SCHERING) à la température ambiante avec une densité de courant de l'ordre de 1A/dm2 pendant une durée sensiblement égale à 23 mn ± 2 mn et l'épaisseur déposée est alors de 15 μ ± 2 μm.

Ce dépôt d'argent présente une parfaite continuité, un état de surface exempt de défaut (rugosité inférieure à 2 μm), une très grande adhérence au matériau composite. Il est clair que, selon les besoins, l'épaisseur de la couche déposée peut varier dans de larges limites.

Les essais de vieillissement accélérés simulés par variations rapide de température suivant la norme NFC 20-714, CEI 68-2-14 (1000 cycles -55°C, + 125°C, dont 1 cycle est composé de 30 mn à -55°C suivi de 30 mn à 125°C), de corrosion en brouillard salin (suivant la norme NFC 20-711, CEI 68-2-13) et de la chaleur humide (suivant la norme NFC 20-703, CEI 68-2-3) ne montrent aucune dégradation du revêtement métallique.

Les mesures électriques d'impédance de surface (Zs) donnent des valeurs de 1 mΩ sur ce type de métallisation, valeur très proche par exemple d'une plaque de cuivre d'épaisseur 35 μm sur un substrat verre-époxy pour application en circuit imprimé. Par définition nous appelons impédance de surface Zs, le rapport entre le champ électrique $\vec{E}$ dans le matériau et la densité de courant surfacique $\vec{J}$ :

$$\vec{E} = Zs \cdot \vec{J}$$

On peut montrer que l'impédance de surface est liée aux caractéristiques du matériau composite métallisé par la relation :

$$Zs = \frac{1}{\sigma d}$$

où σ est la conductivité électrique du métal et d son épaisseur.

Bien entendu, l'exemple de réalisation décrit n'est nullement limitatif de l'invention.

Ainsi, une des autres possibilités concernant le domaine de l'invention réside dans le fait que la métallisation peut être obtenue à partie d'un dépôt d'une sous-couche fine d'accrochage de cuivre par voie chimique, d'un dépôt intermédiaire de cuivre par voie électrolytique et d'un dépôt final de métal présentant de bonnes aptitudes aux brasages tendres mais avec une diminution des caractéristiques de conductivité électrique.

**Revendications**

1.  Procédé pour la métallisation de la surface de pièces en matériau plastique (1), dans lequel on prépare chimiquement la surface desdites pièces, par dégraissage et décapage puis neutralisation chimique, puis on dépose une sous-couche mince (2) d'un premier métal assurant l'adhérence, enfin on effectue un dépôt d'une couche d'un autre métal, ledit procédé étant caractérisé en ce que, ledit matériau plastique étant un matériau composite à matrice organique, ledit procédé comporte en outre, après les étapes de préparation chimique de la surface desdites pièces, les étapes consistant à :
    - obtenir un micro-satinage de la surface des pièces ;
    - étuver pour déshydrater et dégazer lesdites pièces ;
    - déposer par voie chimique une sous-couche très mince (2) d'un métal catalytique ;
    - réaliser un dépôt métallique intermédiaire (3) par voie chimique pour assurer la continuité électrique sur toute la surface des pièces ; et
    - déposer une couche finale (4) de métal très bon conducteur électrique et résistant aux conditions d'environnement, par voie électrolytique ou chimique.

2.  Procédé selon la revendication 1, caractérisé en ce que les pièces (1) sont en matériau composite du groupe comprenant les composites fibres de carbone/résine époxyde et fibres aramides/résine époxyde et en ce que l'étape d'obtenir un micro-satinage consiste à plonger les pièces dégraissées et décapées dans un bain contenant sensiblement de 400 à 450 g/l d'acide chromique et de 180 à 240 ml/l d'acide sulfurique à une température comprise sensiblement entre 68 et 76°C pendant une durée comprise sensiblement entre 4 et 8 mn.

3.  Procédé selon l'une des revendications 1 ou 2, caractérisé en ce que ladite sous-couche très mince (2) est en palladium déposé à partir d'une solution de palladium colloïdal.

4.  Procédé selon la revendication 3, caractérisé en ce que ledit dépôt métallique intermédiaire (3) est constitué par du nickel et en ce que ledit dépôt est réalisé par voie chimique.

5.  Procédé selon l'une quelconque des revendications 1 à 4, caractérisé en ce que ladite couche finale (4) est en argent.

6.  Procédé selon l'une quelconque des revendications 1 à 5, caractérisé en ce que lesdites étapes de dégraissage et de décapage consistent à faire subir auxdites pièces un dégraissage dans une lessive alcaline puis un décapage dans un bain d'acide nitrique concentré contenant environ 10% d'acide fluorhydrique pendant environ 5 mn à la température ambiante, et en ce que ladite étape de neutralisation est effectuée dans un bain de bicarbonate de sodium avec une concentration de l'ordre de 40 à 60 g/l pendant une durée sensiblement comprise entre 3 et 15 mn à la température ambiante.

7.  Pièce en matériau composite à base de résine époxy chargée par des fibres de carbone ou aramides recouvert par au moins une couche métallique électriquement bonne conductrice, caractérisée en ce que la surface micro-satinée dudit matériau composite (1) est recouverte d'une sous-couche mince (2) de palladium, d'un dépôt intermédiaire (3) en nickel et d'une couche finale (4) en argent.

**Office européen des brevets**

# RAPPORT DE RECHERCHE EUROPEENNE

Numero de la demande

EP 93 40 2898

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| X | FR-A-2 660 671 (THOMSON-CSF) <br> * page 1, ligne 19 - ligne 20 * <br> * page 3, ligne 5 - ligne 6 * <br> * page 5, ligne 22 - ligne 25 * <br> --- | 1,3,4,5 | C23C18/24 |
| A | DE-A-21 04 058 (SIEMENS AG) <br> * page 6 - page 7; revendications 1,2,6-9 * <br> --- | | |
| A | DE-A-21 01 049 (SIEMENS AG) <br> * page 6 - page 7; revendications 1,2,5-7 * <br> --- | | |
| A | DE-A-25 38 569 (SIEMENS AG) <br> * page 2, ligne 8 - ligne 13 * <br> ----- | | |

**DOMAINES TECHNIQUES RECHERCHES (Int.Cl.5)**

C23C

Le présent rapport a été établi pour toutes les revendications

| Lieu de la recherche | Date d'achèvement de la recherche | Examinateur |
|---|---|---|
| LA HAYE | 16 Février 1994 | Nguyen The Nghiep, N |

EPO FORM 1503 03.82 (P04C02)